# EUROPEAN PATENT APPLICATION

(11) **EP 4 140 874 A1**
(43) Date of publication of application: **01.03.2023**
(21) Application number: 22187630.3
(22) Date of filing: 28.07.2022
(51) Int. Cl.: B63H 21/17, G01R 31/36

(54) **ELECTRIC MARINE PROPULSION SYSTEM AND CONTROL METHOD WITH EMERGENCY DEPLETION MODE**

(30) Priority: 17.08.2021 US 202117404386
(71) Applicant: Brunswick Corporation, Mettawa, Illinois 60045 (US)
(72) Inventor: Gonring, Steven J., Slinger, WI 53086 (US)
(74) Representative: Sandersons

(57) **Abstract**

An electric marine propulsion system (2) is configured to propel a marine vessel (1) and comprises a lithium ion (LI) battery (18), a marine drive (3) having an electric motor (4) powered by the LI battery (18), and a user input device (60;70) configured to receive a user input selecting an emergency depletion mode. The system further includes a controller (20) configured to determine a battery charge level for the LI battery (18) and reserve a minimum charge level of the LI battery (18) associated with a normal operating area for the LI battery (18) by ceasing power delivery from the LI battery (18) to the marine drive (3) once the battery charge level reaches the minimum charge level. In response to selection of the emergency depletion mode, power is delivered from the LI battery (18) to the marine drive (3) when the battery charge level is below the minimum charge level.

## Description

### BACKGROUND

The following U.S. Patents provide background information and are incorporated herein by reference, in entirety.

U.S. Patent No. 6,507,164 discloses a trolling motor having current based power management including: an electric motor; a motor controller having an output for providing voltage to the motor; and a current sensor for measuring the electrical current flowing through the motor. Upon determining that the trolling motor has been operating above its continuous duty limit for a predetermined period of time, the motor controller begins reducing the voltage output to the motor until reaching an acceptable output voltage. In another embodiment, the controller is operated in three distinct modes with three distinct sets of operating parameters, namely: a normal mode wherein the output is set to a commanded level; a current limit mode wherein the output is set to a safe, predetermined level; and a transitional mode wherein the output is incrementally changed from the predetermined level to the commanded level.

U.S. Patent No. 6,652,330 discloses a method for controlling the electrical system of a marine vessel which comprises the steps of measuring a battery potential, comparing the battery potential to a threshold voltage magnitude, and then disconnecting one or more of a plurality of electrical power consuming devices when the voltage potential is less than the threshold voltage magnitude. This is done to avoid the deleterious condition wherein an engine of the marine vessel is operating at idle speed and attempting to charge the battery while a plurality of electrical power consuming devices are operating and drawing sufficient current from the alternator to prevent the proper charging of the battery. In these circumstances, the battery potential can actually be depleted as the battery attempts to provide the additional required electrical current for the loads.

U.S. Patent No. 6,885,919 discloses a process is provided by which the operator of a marine vessel can invoke the operation of a computer program that investigates various alternatives that can improve the range of the marine vessel. The distance between the current location of the marine vessel and a desired waypoint is determined and compared to a range of the marine vessel which is determined as a function of available fuel, vessel speed, fuel usage rate, and engine speed. The computer program investigates the results that would be achieved, theoretically, from a change in engine speed. Both increases and decreases in engine speed are reviewed and additional theoretical ranges are calculated as a function of those new engine speeds. The operator of the marine vessel is informed when an advantageous change in engine speed is determined.

U.S. Patent No. 7,218,118 discloses a method for monitoring the condition of a battery of a marine propulsion system provides the measuring of a voltage characteristic of the battery, comparing the voltage characteristic to a preselected threshold value, and evaluating the condition of the battery as a function of the relative magnitudes of the voltage characteristic and the threshold value. The voltage characteristic of the battery is measured subsequent to a connection event when a connection relationship between the battery and an electrical load is changed.

U.S. Patent No. 7,385,365 discloses a method for error detection of a brushless electric motor, where at least one first motor parameter is measured or determined, and a second, estimated motor parameter is estimated on the basis of the first motor parameter. The second, estimated motor parameter is compared to a second, measured or determined motor parameter. An error of the electric motor can be found out according to the comparison.

U.S. Patent No. 10,723,430 discloses a propeller propulsion system for a watercraft that includes at least one electric motor and a propeller which can be driven by the electric motor. The propeller is a surface piercing propeller. The propulsion system includes a box-like body having a side wall on which the electric motor is fixed and a cover part on which an outdrive of the surface piercing propeller is applied. The side wall and the cover part include holes through which a shaft of the motor and a shaft of the outdrive respectively pass. The box-like body includes means for transmission of motion from the drive shaft to the outdrive shaft, and the propulsion system includes means for fixing the box-like body to a transom of the watercraft.

### SUMMARY

This Summary is provided to introduce a selection of concepts that are further described below in the Detailed Description. This Summary is not intended to identify key or essential features of the claimed subject matter, nor is it intended to be used as an aid in limiting the scope of the claimed subject matter.

In one embodiment, an electric marine propulsion system is configured to propel a marine vessel and comprises a lithium-ion (LI) battery, a marine drive having an electric motor powered by the LI battery, and a user input device configured to receive a user input selecting an emergency depletion mode. The system further includes a controller configured to determine a battery charge level for the LI battery and reserve a minimum charge level of the LI battery associated with a normal operating area (NOA) for the LI battery by ceasing power delivery from the LI battery to the marine drive once the battery charge level reaches the minimum charge level. In response to selection of the emergency depletion mode, power is delivered from the LI battery to the marine drive when the battery charge level is below the minimum charge level.

In one embodiment, a method of controlling an electric marine propulsion system configured to propel a marine vessel includes determining a battery charge level for a lithium-ion (LI) battery powering the marine drive and reserving a minimum charge level of the LI battery associated with a normal operating area (NOA) for the LI battery by ceasing power delivery from the LI battery to the marine drive once the battery charge level reaches the minimum charge level. User input selecting an emergency depletion mode is received and, in response to the selection, power from the LI battery is delivered to the marine drive when the battery charge level is below the minimum charge level.

Various other features, objects, and advantages of the invention will be made apparent from the following description taken together with the drawings.

### BRIEF DESCRIPTION OF THE DRAWINGS

The present disclosure is described with reference to the following Figures.
FIG. 1 is a schematic depiction of a marine vessel having an exemplary electric marine propulsion system in accordance with the present disclosure.
FIG. 2 is a schematic of another exemplary electric marine propulsion system in accordance with the present disclosure.
FIG. 3 is an exemplary battery housing with a user input device configured to receive a user input selecting an emergency depletion mode in accordance with one embodiment of the present disclosure.
FIG. 4 is an exemplary display configured to receive a user input selecting an emergency depletion mode in accordance with another embodiment of the present disclosure.
FIG. 5 is a flowchart exemplifying methods, or portions thereof, for controlling an electric marine propulsion system in accordance with the present disclosure.

### DETAILED DESCRIPTION

The present inventor has recognized that electric marine propulsion poses additional challenges and safety concerns as compared to electric-powered propulsion for land vehicles. One such challenge that is magnified or increased for marine propulsion is that of battery range and effectively managing range anxiety and battery utilization for users of marine vehicles. Being stranded in a body of water due to insufficient battery is concerning for a user of a marine vessel, and tends to be more so than for a user of a land vehicle because the user cannot easily exit the vessel and may not be in a situation to easily call for or access help. For this reason, users report having increased anxiety when operating electric marine propulsion systems, and particularly have heightened concerns regarding maintaining sufficient battery power to reach their destination and/or reach shore.

Upon recognition of the forgoing challenges in the relevant art, the inventor developed the disclosed system and method that enables a user to access, with express input and consent, more of the power stored in an LI battery in case of emergencies. While doing so may degrade the battery, the inventor has recognized that marine applications may pose circumstances for users where damage to the battery is preferable over being stranded in a body of water.

Lithium-Ion (LI) batteries all have a minimum charge level, or minimum discharge voltage, associated with a normal operating area (NOA) for the battery. The NOA is the normal operating voltage range specified for the battery, setting maximum and minimum voltage levels within which the battery should be maintained to preserve the operation and safety of the battery. In general, LI battery cells should not be depleted to below their minimum charge level, which is typically between 2.4 V and 3.0 V per cell. To provide one example, an LI cell may have a nominal voltage of 3.7V, maximum voltage of 4.2V and minimum voltage of 2.7V. If these limits of the battery are violated-e.g., the minimum charge level is violated where any one or more cells are discharged to less than 2.7V-it can lead to unstable cell conditions. Lithium batteries undergo unwanted chemical reactions when discharged below the minimum charge level, which is likely to cause their internal resistance to be permanently and significantly raised. Their capacity may also suffer, meaning that the maximum amount of charge that the battery cell can store will decrease.

Accordingly, larger LI batteries have a control circuit configured to provide undervoltage protection. To protect the battery and its usable life, the control circuit is configured to disconnect the battery from a load once the charge level reaches or falls below the minimum charge level in order to reserve the minimum charge level and prevent the battery from being over-discharged to a level where degradation occurs.

The disclosed LI battery systems and control methods are configured to allow a user to utilize the power remaining once the battery reaches the minimum charge level. The system is configured to require express user input to engage an emergency depletion mode allowing access to the remaining battery power in case of emergencies. In some embodiments, the disclosed system is configured to provide a warning in association with the user input offering selection of the emergency depletion mode advising the user that utilizing the battery in that mode may damage the battery, void or impact the warranty, etc.

The system includes a user input device configured to receive a user input selecting an emergency depletion mode. The user input device may be a physical element on the batter, such as a switch on the battery or somewhere else on the vessel, or may be an electronic input, such as a button on a display. The controller is configured to reserve the minimum charge level of the LI battery and to cease power delivery from the LI battery to the electric motor once the battery charge level of the battery reaches the minimum charge level unless the emergency depletion mode is selected by the user. In response to selection of the emergency depletion mode, the controller stops reserving the minimum charge level and permits power delivery from the LI battery to the electric motor when the battery charge level is below the minimum charge level.

A warranty void warning may be provided in association with the user input device offering selection of the emergency depletion mode advising a user of a battery warranty policy related to selecting the emergency depletion mode and/or advising a user that engagement of the mode may damage the battery. For example, the warranty void warning may be on the housing of the LI battery adjacent to the selector switch. Alternatively or additionally, the warranty void warning may be presented on a user interface display in conjunction with the option to select the emergency depletion mode.

The controller may be configured to log use of the emergency depletion mode, including logging a date/time of the engagement of the mode, storing the duration (e.g., run-time) that the mode is engaged, storing the minimum charge level or cell voltages within the battery while the mode was engaged, etc.

The controller may further be configured to provide guidance to a user regarding disengaging the emergency depletion mode. For example, the controller may be configured to present a notice to the user to deselect the emergency depletion mode once a predetermined condition is satisfied. For instance, the deselection notice may be provided on a display at the helm or a display associated with the LI battery system. The notice may be provided, for example, once the electric motor is key cycled (i.e., turned off and then back on) after the battery charge level is below the minimum charge level, once a threshold charge current is delivered to the LI battery, and/or once the battery charge level becomes greater than the minimum charge level.

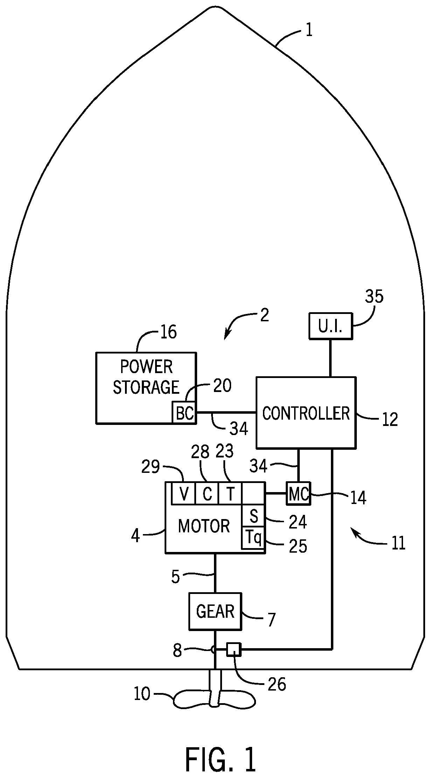

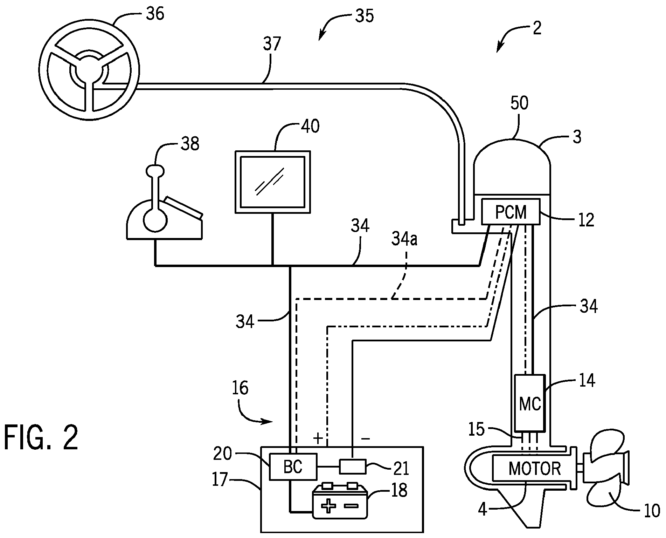

FIG. 1 depicts an exemplary embodiment of a marine vessel 1 having an electric marine propulsion system 2 configured to propel the marine vessel in a direction instructed by an operator via a steering control system, or by a guidance system configured to automatically control steering of the marine vessel to steer the vessel toward a predetermined location or global position. Referring to both the FIG. 1 and FIG. 2 embodiments, the electric propulsion system 2 includes at least one electric marine drive 3 having an electric motor 4 configured to propel the marine vessel 1 by rotating a propeller 10, as well as a power storage system 16, and a user interface system 35. In the embodiment of FIG. 2, the electric marine propulsion system 2 includes an outboard marine drive 3 having an electric motor 4 housed therein, such as housed within the cowl 50 of the outboard marine drive. A person of ordinary skill in the art will understand in view of the present disclosure that the marine propulsion system 2 may include other types of electric marine drives, such as inboard drives or stern drives. The electric marine drive 3 is powered by the one or more batteries 18 in the storage system 16.

The motor 4 may be, for example, a brushless electric motor, such as a brushless DC motor. In other embodiments, the electric motor may be a DC brushed motor, an AC brushless motor, a direct drive, a permanent magnet synchronous motor, an induction motor, or any other device that converts electric power to rotational motion. In certain embodiments, the electric motor 4 includes a rotor and a stator in a known configuration.

The electric motor 4 is electrically connected to and powered by a power storage system 16. The power storage system 16 stores energy for powering the electric motor 4 and is rechargeable, such as by connection to shore power when the electric motor 4 is not in use. The power storage system 16 includes one or more lithium-ion (LI) batteries 18, each LI battery 18 comprised of multiple battery cells.

The electric motor 4 is operably connected to the propeller 10 and configured to rotate the propeller 10. As will be known to the ordinary skilled person in the relevant art, the propeller 10 may include one or more propellers, impellers, or other propulsor devices and that the term "propeller" may be used to refer to all such devices. In certain embodiments, such as that represented in FIG. 1, the electric motor 4 may be connected and configured to rotate the propeller 10 through a gear system 7 or a transmission. In such an embodiment, the gear system 7 translates rotation of the motor output shaft 5 to the propeller shaft 8 to adjust conversion of the rotation and/or to disconnect the propeller shaft 8 from the drive shaft 5, as is sometimes referred to in the art as a "neutral" position where rotation of the drive shaft 5 is not translated to the propeller shaft 8. Various gear systems 7, or transmissions, are well known in the relevant art. In other embodiments, the electric motor 4 may directly connect to the propeller shaft 8 such that rotation of the drive shaft 5 is directly transmitted to the propeller shaft 8 at a constant and fixed ratio.

The power storage system 16 further includes a battery controller 20 configured to monitor and/or control aspects of the power storage system 16. The battery controller 20 may further be configured to receive information from current, voltage, and/or other sensors within the power storage system 16, such as to receive information about the voltage, current, and temperature of each battery cell or group of battery cells within each battery 18 of the power storage system 16. For example, the battery controller 20 may receive inputs from one or more sensors within the power storage system 16, such as one or more voltage, current, and temperature sensors within a housing for the power storage system 16, which in some embodiments is a housing of a single LI battery 18. Voltage sensors may be configured to sense voltage within the battery 18 (such as cell voltage sensors configured to sense the voltage of individual cells or groups of cells in a LI battery) and one or more temperature sensors may be configured to sense a temperature within a housing of the battery 18 or a housing where one or more batteries or other storage elements are located. The battery controller 20 or other controller in the system is configured to calculate a charge level, such as a state of charge, of each battery 18.

Each electric motor 4 may be associated with a motor controller 14 configured to control power to the electric motor, such as to the stator winding thereof. The motor controller 14 is configured to control the function and output of the electric motor 4, such as controlling the torque outputted by the motor, the rotational speed of the motor 4, as well as the input current, voltage, and power supplied to and utilized by the motor 4. In one arrangement, the motor controller 14 controls the current delivered to the stator windings via the leads 15, which input electrical energy to the electric motor to induce and control rotation of the rotor.

Sensors may be configured to sense the power, including the current and voltage, delivered to the motor 4. For example, a voltage sensor 29 may be configured to sense the input voltage to the motor 4 and a current sensor 28 may be configured to measure input current to the motor 4. Accordingly, power delivered to the motor 4 can be calculated and such value can be used for monitoring and controlling the electric propulsion system 2, including for monitoring and controlling the motor 4. In the depicted example, the current sensor 28 and voltage sensor 29 may be communicatively connected to the motor controller 14 to provide measurement of the voltage supplied to the motor and current supplied to the motor. The motor controller 14 is configured to provide appropriate current and or voltage to meet the demand for controlling the motor 4. For example, a demand input may be received at the motor controller 14 from the central controller 12, such as based on an operator demand at a helm input device, such as the throttle lever 38. In certain embodiments, the motor controller 14, voltage sensor 29, and current sensor 28 may be integrated into a housing of the electric motor 4, in other embodiments the motor controller 14 may be separately housed.

Various other sensors may be configured to measure and report parameters of the electric motor 4. For example, the electric motor 4 may include means for measuring and or determining the torque, rotation speed (motor speed), current, voltage, temperature, vibration, or any other parameter. In the depicted example, the electric motor 4 includes a temperature sensor 23 configured to sense a temperature of the motor 4, a speed sensor 24 configured to measure a rotational speed of the motor 4, and a torque sensor 25 for measuring the torque output of the motor 4. A propeller speed sensor 26 may be configured to measure a rotational speed of the propeller 10. For example, the propeller speed sensor 26 and/or the motor speed sensor 24 may be a Hall Effect sensor or other rotation sensor, such as using capacitive or inductive measuring techniques. In certain embodiments, one or more of the parameters, such as the speed, torque, or power to the electric motor 4, may be calculated based on other measured parameters or characteristics. For example, the torque may be calculated based on power characteristics in relation to the rotation speed of the electric motor.

The power mode limitations are governed by the control system 11, such as by the central controller 12. The electric propulsion system 2 may include a plurality of controllers communicatively connected and configured to cooperate to provide the method of controlling the electric marine propulsion system described herein. For example, the motor controller 14, battery controller 20, and central controller 12 and may cooperate as a distributed control system 11 to effectuate control of the marine propulsion system 2 as described herein such that the selected power usage limitations are implemented and the battery power of the power storage system 16 is conserved. A person of ordinary skill in the art will understand in view of the present disclosure that other control arrangements are available and that the control functions described herein may be combined into a single controller or divided into any number of a plurality of distributed controllers that are communicatively connected.

In certain embodiments, various sensing devices 23-25, 26, and 28-29, may be configured to communicate with a local controller, such as the motor controller 14 or battery controller 20, and in other embodiments the sensors 23-25, 26, and 28-29 may communicate with the central controller 12 and one or more of the motor controller 14 and or battery controller 20 may be eliminated. Controllers 12, 14, 20 (and or the sensors) may be configured to communicate via a communication link 34 such as a CAN bus or a LIN bus, or by single dedicated communication links between controllers 12, 14, 20. In the example at FIG. 2, the battery controller 20 communicates with the propulsion controller 12 via dedicated communication link 34a, and also communicates on communication link 34 so as to enable communication with helm devices, etc.

Each controller may comprise a processor and a storage device, or memory, configured to store software and/or data utilized for controlling and or tracking operation of the electric propulsion system 2. The memory may include volatile and/or non-volatile systems and may include removable and/or non-removable media implemented in any method or technology for storage of information. The storage media may include non-transitory and/or transitory storage media, including random access memory, read only memory, or any other medium which can be used to store information and be accessed by an instruction execution system, for example. An input/output (I/O) system provides communication between the control system 11 and peripheral devices.

The central controller 12, which in the embodiment shown in FIG. 2 is a propulsion control module (PCM), communicates with the motor controller 14 via communication link 34, such as a CAN bus. The controller also receives input from and/or communicates with one or more user interface devices in the user interface system 35 via the communication link 34, which in some embodiments may be the same communication link as utilized for communication between the controllers 12, 14, 20 or may be a separate communication link. The user interface devices in the exemplary embodiment include a throttle lever 38 and a display 40. In various embodiments, the helm display 40 may be, for example, part of an onboard management system, such as the VesselView^{™} by Mercury Marine of Fond du Lac, Wisconsin. A steering wheel 36 is provided, which in some embodiments may also communicate with the controller 12 in order to effectuate steering control over the marine drive 3, which is well-known and typically referred to as steer-by-wire arrangements. In the depicted embodiment, the steering wheel 36 is a steer arrangement where the steering wheel 36 is connected to a steering actuator that steers the marine drive 3 by a steering cable 37. Other steer arrangements, such as various steer-by-wire arrangements, are well-known in the art and could alternatively be implemented.

The power storage system 16 may further be configured to power auxiliary devices on the marine vessel 1 that are not part of the propulsion system 2. For example, the auxiliary devices may include a bilge pump, a cabin lights, a stereo system or other entertainment devices on the vessel, a water heater, a refrigerator, an air conditioner or other climate/comfort control devices on the vessel, communication systems, navigation systems, or the like. Some or all of these accessory devices are sometimes referred to as a "house load" and may consume a substantial amount of battery power. In the emergency depletion mode, the control system may be configured to turn off or otherwise cease power delivery to one or more of the house load devices so as to optimize use of battery power for propelling the marine vessel and only conducting activities that are essential for propulsion and/or passenger safety.

The battery controller 20 is configured to determine the battery charge level for the LI battery 18, such as based on cell voltage measurements. For example, the charge level may be determined as a state of charge (SOC) of the battery 18 or an average SOC across all batteries 18 within the power storage system 16. For example, the controller 20 may determine SOC by tracking the amount of energy going into and out of the battery over a time. This method, commonly referred to as "coulomb counting," may be utilized for lithium-ion batteries where discharge curve is very flat and thus it may be difficult to determine SOC based on voltage measurements alone. Alternatively, in certain configurations the charge level may be a voltage level of the battery 18, such as an average of the measured cell voltages, or the charge level may be determined by another method of quantifying the stored energy available and/or remaining in the battery 18.

The controller is configured to reserve a minimum charge level of the LI battery 18, such as a minimum voltage associated with a normal operating area for the LI battery 18. Accordingly, the controller is configured to cease power delivery from the LI battery 18 to various load elements, such as including the marine drive 3. For example, the system may include a battery disconnect switch 21 (FIG. 2) configured to disconnect the LI battery 18 from the marine drive and/or other load devices once the battery charge level reaches minimum charge level. For example, the battery disconnect switch 21 may be positioned within the housing 17 of the power storage system 6 and configured to disconnect the battery 18 from the load on the marine vessel, including disconnection of the marine drive 3. Alternatively, the battery disconnect switch 21 may be positioned elsewhere, such as between the power storage device 16 and one or more of the load devices, including the marine drive. The controller 20 may be configured to open the battery disconnect switch 21 connecting the LI battery to the marine drive 3 once the battery charge level reaches the minimum charge level when the emergency depletion mode is not selected. If the emergency depletion mode is selected, then the battery connect switch is closed (if previously opened) and power delivery to the marine drive 3 is resumed.

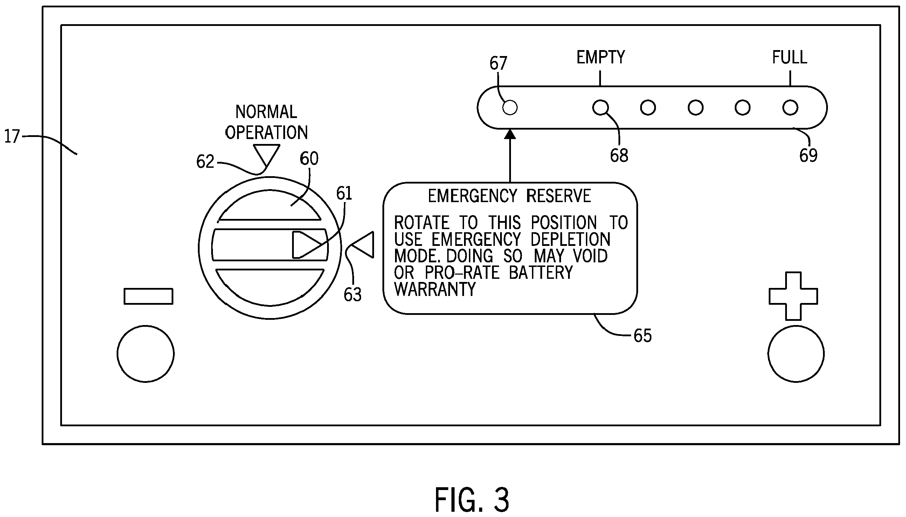

The power delivery from the LI battery remains unavailable unless and until user input is provided to engage the emergency depletion mode. The system includes a user input device configured to receive a user input selecting the emergency depletion mode. For example, the user input device may be a physical device associated with or connected to the power storage system 16. FIG. 3 depicts one such embodiment where the user input device is a selector switch 60 positionable to select and deselect the emergency depletion mode. In the depicted example, the selector switch 60 is on the housing 17 of the power storage system 16 containing the LI battery 18. In other embodiments, the selector switch 60 may be positioned elsewhere, such as when the power storage system 16 is not easily accessible. For example, the selector switch 60 may be positioned at or near the helm or otherwise on the vessel near the vicinity of the power storage system 16. The selector switch 60 is movable between a position where the emergency depletion mode is not selected and a position where the emergency depletion mode is selected. In the example at FIG. 3, the emergency depletion mode selected when the position marker 61 on the selector switch 60 is aligned with selection position marker 63 indicated on the housing. The emergency depletion mode is deselected when the marker 61 is aligned with position indicator 62, which engages normal operation.

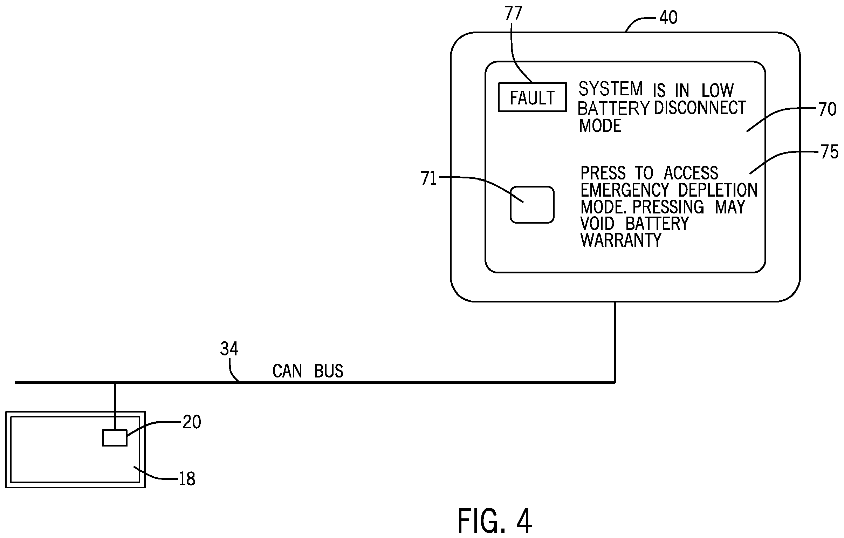

In other embodiments, the user input device is a user interface display configured to present an option to a user to select and deselect the emergency depletion mode. For example, the display may be a helm display. In other embodiments, the display may be a display on the housing 17 of the power storage system 16 or otherwise a dedicated display for providing information about the power storage system 16. FIG. 4 provides one embodiment of a digital user interface display 70 provided on a display device, such as on helm display 40. The digital user interface display 70 includes a selectable element 71 selectable on the display to select and deselect, or engage or disengage, the emergency depletion mode. In one embodiment, the control system 11 may be configured to present the selection option to the user for selecting the emergency depletion mode once the battery charge level has reached a threshold low value, such as a predetermined battery charge level that is equal to or slightly greater than the minimum charge level. Thus, the option for selecting the emergency depletion mode may only be provided once power delivery from the LI battery to the marine drive has ceased, or other embodiments immediately prior to ceasing power delivery from the LI battery.

The system may be configured to provide a warranty void warning to a user in association with the user input device for selecting the emergency depletion mode. The warranty void warning may be a fixed warning label on the battery housing or may be on a digital display, and is configured to advise a user of the battery warranty policy related to selecting the emergency depletion mode and/or advise the user of negative implications of selecting the mode, such as damaging the battery. In other words, the system may be configured to advise the user of the gravity of selecting the emergency depletion mode and/or to verify the users intent for selected the mode and acknowledgement of the implications of doing so. In the example at FIG. 3, a warning label 65 is placed on the housing 17 adjacent to the selection position marker 63 associated with selecting the emergency depletion mode. The label provides a warranty void warning advising the user that selecting the emergency depletion mode may void or pro-rate the battery warranty. A similar warranty void warning may be provided on a digital display, as exemplified in FIG. 4. The warranty void warning 75 is provided adjacent to the selectable element 71 to advise the user regarding the battery warranty policy and implications relating to selecting the emergency depletion mode.

The system may further be configured to provide notice to the user once the battery 18 is disconnected from the marine drive due to reaching the minimum charge level. The notice may be configured to prompt the user, or indicate an option to the user, to engage the emergency depletion mode. In the example at FIG. 3, an indicator light 67 is configured to be illuminated to indicate that power is no longer being delivered from the LI battery 18 due to low charge level, or low battery voltage. The LED indicator is configured such that, upon seeing it illuminated the user will notice the selector switch 60 and will be prompted to consider whether to engage the emergency depletion mode. In the example at FIG. 4, the "fault" notice 77 is provided on the digital user interface display 70 advising a user of the battery condition and that the delivery has ceased due to low battery charge level, such as low SOC.

The system may be configured to provide additional indicators, such as charge status indicators and indicators configured to notify the user that the emergency depletion mode is engaged. In the example at FIG. 3, the charge status indicator 69 is a series of LEDs indicating the charge status of the battery between empty and full. In one embodiment, the same charge status indicator 69 may be utilized to indicate that the emergency depletion mode is engaged. For example, one or more of the LEDs of the charge status indicator 69 may illuminate in a predetermined pattern, such as flashing, or may illuminate in a different color when the emergency depletion mode is engaged. To provide one further example, the LED 68 indicates empty when it is the last remaining illuminated light, and it may be configured to flash or change color when the emergency depletion mode is engaged. Alternatively, the indicator light 67 may be configured to flash or otherwise change illumination once the emergency depletion mode is engaged. In an embodiment where the system is configured for selection of emergency reserve mode on a digital display, such as user interface display 70 in FIG. 4, the digital display may be controlled to provide a separate indicator of battery charge status and a separate notice regarding engagement of the emergency depletion mode.

In certain embodiments, the system may be configured to provide a notice to the user to deselect the emergency depletion mode, such as once a predetermined restart condition is satisfied. For example, the notice may be provided on the display 40 at the helm advising the user to deselect the emergency depletion mode at whatever means it was originally selected, whether by a physical switch, such as selector switch 60 on the housing 17, or on the digital user interface display 70. For example, the predetermined restart condition may be once the marine drive is turned off and back on, or key cycled, after the emergency depletion mode is engaged, delivering a charge current to the LI battery 18 while the emergency depletion mode is engaged and/or the battery charge level becoming greater than the minimum charge level while the emergency depletion mode is engaged. Alternatively or additionally, the system may be configured to automatically deselect the emergency depletion mode once he predetermined restart condition is satisfied.

When the emergency depletion mode is engaged, the control system 11 may be configured to control the electric marine propulsion system 2 to limit the rate of discharge of the battery 18 to maximize power usage for propulsion. The various parameters of the electric propulsion system may be utilized for providing user-controlled or automatically effectuated vessel power control functionality while in the emergency depletion mode appropriate for optimizing power usage when the amount of remaining power stored in the power storage system is low. For example, the control system 11 may be configured to limit the amount of power provided from the battery 18. Alternatively or additionally, the control system 11 may be configured to control the motor 4 so as not to exceed a specified wattage or other power usage requirement, or so as not to exceed a specified rate of rotation (RPM) or thrust. Thereby, the system may be configured to manage the amount of power drawn from the battery 18 while in the emergency depletion mode.

In certain embodiments, the system is configured to create a log of incidents where the emergency depletion mode is engaged and/or where the battery charge level becomes less than the minimum charge level. For example, the battery controller 20 may be configured to log such incidents, referred to herein as below NOA incidents, in order to create a record of engagement of the emergency depletion mode. The below NOA incident log tracks the users activity in relation to utilization of the emergency depletion mode and provides information to a service technician regarding damage that may have been done to the battery by operating in that mode. The system may be configured to store, in association with each below NOA incident, information relating to usage of the battery while in that mode and/or when the battery charge level become less than the minimum charge level. For example, the battery controller 20 may be configured to store at least one of a run time below the minimum charge level and/or a lowest battery charge level for the LI battery while the emergency depletion mode is engaged. In certain embodiments, the controller 20 may be configured to periodically store the charge level to track it throughout the entire period that the battery is operated in the emergency depletion mode.

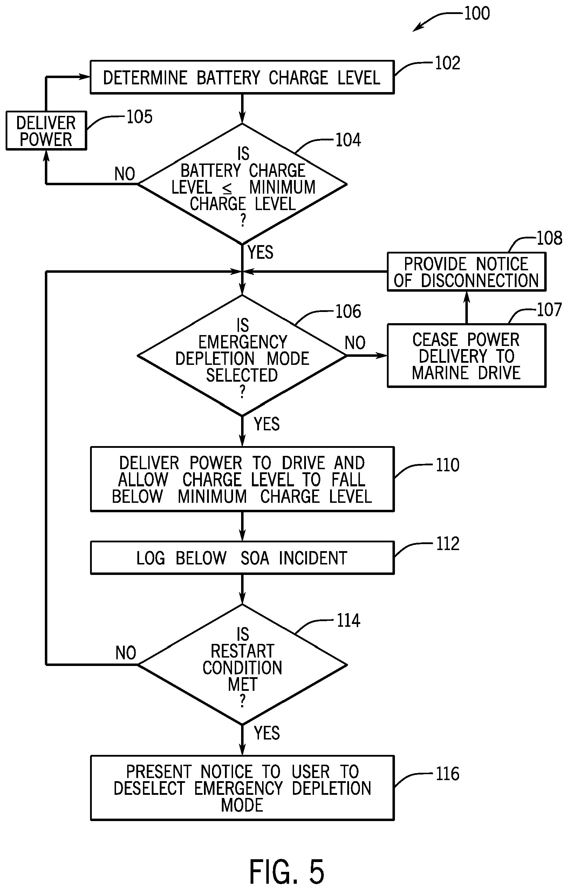

FIG. 5 depicts one example of a method 100 of controlling an electric marine propulsion system. A battery charge level is determined at step 102, such as a state of charge for a single LI battery 18 or a power storage system 16 containing multiple LI batteries 18. The battery charge level is compared to a minimum charge level at step 104. Provided that the battery charge level remains above the minimum charge level, then power delivery is provided at step 105, such as to the marine drive 3 propelling the marine vessel. Once the battery charge level becomes less than or equal to the minimum charge level, then step 106 is executed to identify whether the emergency depletion mode is selected, and thus has been engaged by the user. If not, then power delivery is ceased at step 107, including ceasing power delivery from the LI battery 18 to the marine drive 3. Notice of disconnection is provide at step 108 notifying the user that power delivery has been cut off due to low SOC of the battery, such as illuminating the indicator light 67.

Once the emergency depletion mode is selected at step 106, power delivery is resumed and the charge level is allowed to fall below the minimum charge level, as represented at step 110. A below NOA incident is logged at step 112, such as including the date and time of the input selecting the emergency depletion mode, a record of the system run time while the emergency depletion mode is engaged (which could be a run time of the marine drive 3 or a run time of that any propulsion load and/or house load element is drawing power from the power storage system 16), periodic storage of the charge level while the emergency depletion mode is engaged, the lowest charge level recorded while the emergency depletion mode is engaged, and/or the like.

Once a restart condition is satisfied at step 114, then a notice is presented to the user to deselect the emergency depletion mode at step 116. Alternatively or additionally, the system may be configured to automatically deselect the emergency depletion mode once the predetermined restart condition is satisfied. For example, the predetermined restart condition may be key cycling the marine drive while the emergency depletion mode is selected, delivering a charge current to the LI battery 18 while the emergency depletion mode is selected, and/or the battery charge level becoming greater than the minimum charge level while the emergency depletion mode is selected.

This written description uses examples to disclose the invention, including the best mode, and also to enable any person skilled in the art to make and use the invention. Certain terms have been used for brevity, clarity and understanding. No unnecessary limitations are to be inferred therefrom beyond the requirement of the prior art because such terms are used for descriptive purposes only and are intended to be broadly construed. The patentable scope of the invention is defined by the claims, and may include other examples that occur to those skilled in the art. Such other examples are intended to be within the scope of the claims if they have features or structural elements that do not differ from the literal language of the claims, or if they include equivalent features or structural elements with insubstantial differences from the literal languages of the claims.

## Claims

1. An electric marine propulsion system (2) configured to propel a marine vessel (1), the system comprising:
a lithium-ion (LI) battery (18);
a marine drive (3) having an electric motor (4) powered by the LI battery (18);
a user input device (60;70) configured to receive a user input selecting an emergency depletion mode;
a controller (20) configured to:
determine a battery charge level for the LI battery (18);
reserve a minimum charge level of the LI battery (18) associated with a normal operating area (NOA) for the LI battery (18) by ceasing power delivery from the LI battery (18) to the marine drive (3) once the battery charge level reaches the minimum charge level;
in response to selection of the emergency depletion mode, deliver power from the LI battery (18) to the marine drive (3) when the battery charge level is below the minimum charge level.

2. The system of claim 1, wherein the controller (20) is further configured to, upon selection of the emergency depletion mode and/or upon the battery charge level becoming less than the minimum charge level, log a below NOA incident.

3. The system of claim 2, wherein the controller (20) is further configured to, in association with the below NOA incident, store at least one of a run time below the minimum charge level and a lowest battery charge level for the LI battery (18).

4. The system of claim 1, 2 or 3, wherein the user input device (60;70) is a selector switch (60) positionable to select and deselect the emergency depletion mode.

5. The system of claim 4, wherein the selector switch (60) is on a housing (17) of a power storage system (16) containing the LI battery (18), optionally further comprising a warranty void warning (65) on the housing (17) adjacent to the selector switch (60) and advising a user of a battery warranty policy related to selecting the emergency depletion mode.

6. The system of claim 1, 2 or 3, wherein the user input device (60;70) is a user interface display (70) configured to present an option to a user to select and deselect the emergency depletion mode, optionally wherein the controller (20) is further configured to provide a warranty void warning (75) on the user interface display (70) in conjunction with the option to select the emergency depletion mode and advising a user of a battery warranty policy related to selecting the emergency depletion mode.

7. The system of any one of claims 1-6, further comprising a user interface display (40) configured to present a notice to the user to deselect the emergency depletion mode once a predetermined restart condition is satisfied, optionally wherein the predetermined restart condition is at least one of key cycling the marine drive (3) while the emergency depletion mode is selected, delivering a charge current to the LI battery (18) while the emergency depletion mode is selected, and the battery charge level becoming greater than the minimum charge level while the emergency depletion mode is selected.

8. The system of any one of claims 1-6, wherein the controller (20) is further configured to automatically deselect the emergency depletion mode once a predetermined restart condition is satisfied, optionally wherein the predetermined restart condition is at least one of key cycling the marine drive (3) while the emergency depletion mode is selected, delivering a charge current to the LI battery (18) while the emergency depletion mode is selected, and the battery charge level becoming greater than the minimum charge level while the emergency depletion mode is selected.

9. A method of controlling an electric marine propulsion system (2) configured to propel a marine vessel (1), the method comprising:
determining, at a controller (20), a battery charge level for a lithium-ion (LI) battery (18) powering a marine drive (3);
reserving, with the controller (20), a minimum charge level of the LI battery (18) associated with a normal operating area (NOA) for the LI battery (18) by ceasing power delivery from the LI battery (18) to the marine drive (3) once the battery charge level reaches the minimum charge level;
receiving, at the controller (20), a user input selecting an emergency depletion mode;
in response to selection of the emergency depletion mode, delivering power from the LI battery (18) to the marine drive (3) when the battery charge level is below the minimum charge level.

10. The method of claim 9, wherein ceasing power delivery from the LI battery (18) to the marine drive (3) includes controlling a battery disconnect switch (21) to open connection between the LI battery (18) and the marine drive (3) once the battery charge level reaches the minimum charge level when the emergency depletion mode is not selected, optionally wherein stopping reservation of the minimum charge level includes, when the emergency depletion mode is selected, controlling the battery disconnect switch (21) to remain closed once the battery charge level is at or below the minimum charge level.

11. The method of claim 9 or 10, further comprising, upon selection of the emergency depletion mode and/or upon the battery charge level becoming less than the minimum charge level, logging a below NOA incident, optionally further comprising, in association with the logged below NOA incident, storing at least one of a run time below the minimum charge level and a lowest battery charge level for the LIl battery (18).

12. The method of claim 9, 10 or 11, wherein the user input selecting the emergency depletion mode is a position of a selector switch (60).

13. The method of any one of claims 9-12, further comprising presenting a warranty void warning in association with a user input device (60;70) for selecting the emergency depletion mode advising a user of a battery warranty policy related to selecting the emergency depletion mode.

14. The method of any one of claims 9-13, further comprising presenting a notice to the user to deselect the emergency depletion mode once a predetermined restart condition is satisfied, optionally wherein the predetermined restart condition is at least one of key cycling the marine drive (3) while the emergency depletion mode is selected, delivering a charge current to the LI battery (18) while the emergency depletion mode is selected, and the battery charge level becoming greater than the minimum charge level while the emergency depletion mode is selected.

15. The method of any one of claims 9-13, further comprising automatically deselecting the emergency depletion mode once a predetermined restart condition is satisfied, wherein the predetermined restart condition is at least one of key cycling the marine drive (3) while the emergency depletion mode is selected, delivering a charge current to the LI battery (18) while the emergency depletion mode is selected, and the battery charge level becoming greater than the minimum charge level while the emergency depletion mode is selected.
